# EUROPEAN PATENT APPLICATION

(11) **EP 3 185 323 A1**
(43) Date of publication of application: **28.06.2017**
(21) Application number: 17154988.4
(22) Date of filing: 11.05.2015
(51) Int. Cl.: H01L 51/44, H01L 51/46

(54) **DOPED PEROVSKITES AND THEIR USE AS ACTIVE AND/OR CHARGE TRANSPORT LAYERS IN OPTOELECTRONIC DEVICES**

(30) Priority: 09.05.2014 EP 14001735
(62) Divisional of application: 15167145.0
(71) Applicant: Novaled GmbH, 01307 Dresden (DE)
(72) Inventor: POLANDER, Laura, 01307 Dresden (DE); KÖRNER, Christian, 01307 Dresden (DE); LEO, Karl, 01307 Dresden (DE)
(74) Representative: Bittner, Thomas L.

(57) **Abstract**

The invention relates to an optoelectronic devices arranged on a substrate and comprising a first electrode (2) adjacent to the substrate (3) and a second electrode (7) which is arranged on top of the device, at least one perovskite layer comprising an perovskite structure, and at least one charge transport layer (4; 6) which is arranged between the first and the second electrode (2, 7). The at least one charge transport layer (4; 6) is doped from 0.001 to 15 percent by weight (wt.-%) with a dopant material based on the total weight of the finished charge transport layer (4; 6).

## Description

The present invention relates to doped perovskites and / or doped charge-transport layers and their use as active and / or charge transport layers in perovskite-based optoelectronic devices.

### Background

Most modern semiconductor devices use single crystalline layers. For modern electronics, however, using thin films is often advantageous, e.g. for flexible devices. For this purpose, a number of different organic and inorganic materials have been considered. Recently, organic-inorganic perovskites have gained much interest due to their excellent device performance with conversion efficiencies of over 20% (KRICT (2015) New ion continues perovskite solar's flat-out progress *Press Release*).

Organic-inorganic perovskites are a particularly promising class of crystalline organic-inorganic hybrids. Their crystalline nature and the rigid, extended inorganic framework provide an opportunity for higher electrical mobility, better thermal stability, and templating of the organic component of the structure. The organic component may consist of a bilayer (e.g. monoammonium) or monolayer (e.g. diammonium) of organic cations.

The most commonly used organic-inorganic perovskite-structured semiconductors in photovoltaics incorporate methylammonium and lead cations along with halide anions to form the general structure CH₃NH₃PbX₃ where X can be Br, Cl, I, or a mixture therefrom. They exhibit high charge carrier mobility values and remarkably long charge carrier diffusion lengths (> 1 µm) making them particularly well suited for photovoltaic applications (Grätzel, M. (2014) The light and shade of perovskite solar cells. Nat Mater 13, 838-842; Hodes, G. (2013). Perovskite-Based Solar Cells. Science 342 (6156): 317-318). Additionally, the inexpensive precursors and low-temperature deposition techniques compatible for thin-film production make perovskites intriguing for commercial applications.

Solar cells based on methylammonium trihalide (CH₃NH₃PbX₃, X= Cl, Br, I) pervoskites have been realized in combination with various materials and in different device designs. Examples include a solid-state electrolyte based dye-sensitized configuration using a mesoporous TiO2 photoanode, a meso-superstructured device configuration consisting of a mesoporous alumina insulator scaffold, and a simple planar heterojunction configuration. In these devices, perovskite thin films are most commonly deposited by solution methods (typically spin-coating), but vacuum deposition methods have also been successfully implemented to achieve highly uniform layers (Malinkiewicz, O. et al. (2014) Perovskite solar cells employing organic charge-transport layers. Nat Photon 8, 128-132). Specifically, Liu, et al. described planar heterojunction cells using CH3NH3PbX3 (X = Cl, I) demonstrating efficiencies of 8.6 % for solution processed cells and up to 15.4 % for vacuum deposited analogues (Liu, M. et al. (2013) Efficient planar heterojunction perovskite solar cells by vapor deposition. Nature 501, 395-398).

Regardless of the form, most of these optoelectronic device architectures use a photoactive perovskite layer combined with solid-state hole- and electron-transport materials to form heterojunctions - designs modeled after those typically used for dye-sensitized solar cells and organic-based photovoltaics. However, in contrast to most inorganic and organic solar cells, active Fermi level control has not yet been employed in the emerging field of perovskite photovoltaics.

An organic-inorganic hetero structure electroluminescent device using a layered perovskite semiconductor was proposed (Era et al., "Organic-inorganic heterostructure electroluminescent device using a layered perovskite semiconductor (C6H5C2H4NH3)2Pbl4", Applied Physics Letters Vol. 65, no. 6, 08 August 1994, p. 676-678).

Lead-free organic-inorganic tin halide perovskites have been proposed for photovoltaic applications (N. Noel et al., "Lead-free organic-inorganic tin halide perovskites for photovoltaic applications", Energy & Environmental Science, Vol. 7, no. 9, 01 January 2014, p. 3061-3068).

A dye-sensitized solar cell based on titanium dioxide was proposed (I. Chung et al., "All-solid-state dye-sensitized solar cells with high efficiency", Nature, Vol. 485, no. 7399, 01 January 2012, p. 486-489). The solar cell consists of CsSnI2.95F0.05 doped with SNF2, nano-porous TIO2 and the dye N719.

Document US 2008 / 0014463 A1 refers to a luminescent material and the use of such material in photovoltaic applications.

Semiconducting tin and lead iodide perovskites with organic cations have been described (C. Stoumpos et al., "Semiconducting Tin and Lead Iodide Perovskites with Organic Cations: Phase Transitions, High Mobilities, and Near-Infrared Photoluminescent Properties", Inorganic Chemistry, Vol. 52, no. 15, 05 August 2013, p. 9019-9038).

Therefore, it is an object of the present invention to extensively reduce recombination losses in perovskite-based optoelectronic devices (e.g. transistors, light-emitting diodes, solar cells), while favoring high charge-extraction rates and achieve efficiencies beyond the current status.

### Summary

The invention is focused on the previously unexplored use of molecular or atomic dopants to achieve Fermi level control within the surrounding layer(s) (preferably charge transport layers) and / or perovskite layer(s) in order improve the performance of hetero-junction perovskite-based optoelectronic devices (e.g., transistors, light-emitting diodes, solar cells) beyond the state-of-the art, but also to fabricate, for the first time, homo-junction perovskite-based devices that could not be otherwise achieved without the use of active Fermi level control. The realization of such devices could specifically revolutionize the solar cell industry by enabling the fabrication of high performance solar cells using readily available precursors, potentially opening the door for very inexpensive, marketable devices.

In particular, Fermi level control has several key advantages, such as
- in transistors:
   ∘ reduction of the contact resistance;
   ∘ improvement of the on-off ratio by control of charge carrier concentration in the channel;
- in light-emitting diodes (LEDs):
   ∘ reduction of the voltage due to lower transport layer and interface resistance;
   ∘ wider choice or possible electrodes;
- in solar cells:
   ∘ formation of a p-n or p-i-n homojunction, thus avoiding hetero-interfaces in the active region;
   ∘ optimization of the built-in voltage, which helps to extract carriers from the device;
   ∘ the realization of good electrode contact regardless of energy barriers;
   ∘ the use of highly conductive layers, avoiding ohmic losses.

To achieve these benefits, we propose to use doping techniques. In organic LEDs and solar cells, this technique can be applied both for the perovskites and the other layers in the device architecture. As the doping techniques, we propose to use atomic or molecular addenda to the layers, e.g. such as discussed in a recent article (Walzer, K. et al. (2007) Highly efficient organic devices based on electrically doped transport layers. Chem. Rev. 107, 1233-1271), as well as stoichiometric control of the perovskite material itself to achieve Fermi level shift. It has been shown in recent articles that the Fermi level of the perovskite layer can be significantly shifted by substituting one or more atoms in the chemical structure; however, very limited examples have been explored thus far and this approach has been focused on absorption tuning rather than Fermi level alignment in the device.

An optoelectronic device according to claim 1 is provided.

For the sake of clarity, doping hereinafter refers to adding small percentage of an inorganic and / or organic monomolecular interference (e.g. ions ore molecules) into the (poly-)crystalline structure of the perovskite leading to a mixed layer with tuned Fermi level and increased conductivity. The dopant is an electrical dopant. Electrical dopants are classified in p-dopants and n-dopants. Herein "n" or "p" denotes a n(egative) doping or p(ositive) doping which results in an increase in the density of free electrons and holes in the thermal equilibrium state of the doped material, respectively.

The dopant concentration in the layer comprising the perovskite structure is between 0.001 and 30 wt%, more preferably between 0.01 and 15 wt%, most preferably between 0.1 and 10 wt%.

Advantageously, selecting a doped perovskite as layer material in optoelectronic devices minimizes energy losses while favoring high charge-extraction rates and achieve efficiencies beyond the current status.

The optoelectronic device is arranged on a substrate, e.g. glass, polymer foil or the like, comprising a first electrode adjacent to a substrate and a second electrode which is arranged on top of the device acting as a counter electrode. Preferably, between the first and second electrode, at least two layers are present comprising a perovskite and / or other charge transport material(s) that can be doped to control the Fermi level. The optoelectronic device of the invention may and thus function without such a charge transporting material layer.

The doped perovskite can simultaneously act as the active layer as well as a charge-transport layer.

The layer comprising doped perovskite may be the active layer.

An optoelectronic device as described above may be provided, wherein the layer comprising the doped perovskite is at least one charge-transport layer.

The charge-transport layer can be a hole-transport layer (HTL) or an electron-transport layer (ETL). Additionally, by doping the perovskite layer, the

Fermi level of this layer can be shifted in that way that the perovskite layer can also serve as HTL or ETL.

The perovskite is may be p-doped, wherein the dopant is a molecular dopant chosen to have an electron affinity (EA) larger than 5.0 eV (e.g., F4-TCNQ (Tetrafluoro-tetracyano-quinodimethane, EA = 5.2 eV), F6-TCNNQ (1,3,4,5,7,8-hexafluorotetracyanonaphtha-quinodimethane, EA = 5.7 eV), C60F36 (EA = 5.4 eV), NDP9 (proprietary dopant from Novaled, GmbH), molybdenum oxide (EA = 6.7 eV), an inorganic dopant containing atoms selected from group III of the Periodic Table of Elements, or a dopant containing varied halogen atoms such as F, Cl, I and / or organic cations that can incorporate into the perovskite lattice structure.

The perovskite is may be n-doped, wherein the dopant is a molecular dopant chosen to have an ionization potential (IP) smaller than 4.5 eV (e.g., W2(hpp)4 (Tetrakis(1,3,4,6,7,8-hexahydro-2H-pyrimido[1,2-a]pyrimidinato)-ditungsten (II), IP = 2.7 eV) or Cr2(hpp)4 (tetrakis(1,3,4,6,7,8-hexahydro-2H-pyrimido[1,2-a]pyrimidinato)-dichromium (II), IP = 3.9 eV), an inorganic dopant containing atoms selected form group V of the Periodic Table of Elements, or a dopant containing varied halogen atoms such as F, Cl, I and / or organic cations that can incorporate into the perovskite lattice structure.

The charge carrier transport layer with doped perovskite may be a hole transport layer (HTL) wherein the dopant is a molecular dopant chosen to have an electron affinity (EA) larger than 5.0 eV (e.g., F4-TCNQ (Tetrafluoro-tetracyano-quinodimethane, EA = 5.2 eV), F6-TCNNQ (1,3,4,5,7,8-hexafluorotetracyanonaphthoquinodimethane, EA = 5.7 eV), C60F36 (EA = 5.4 eV), NDP9 (proprietary dopant from Novaled, GmbH), molybdenum oxide (EA = 6.7 eV).

The doped perovskite layer may be an electron transport layer (ETL) wherein the dopant is chosen to have an ionization potential (IP) smaller than 3.5 eV (e.g., W2(hpp)4 (Tetrakis(1,3,4,6,7,8-hexahydro-2H-pyrimido[1,2-a]pyrimidinato)-ditungsten (II), IP = 2.7 eV) or Cr2(hpp)4 (tetrakis(1,3,4,6,7,8-hexahydro-2H-pyrimido[1,2-a]pyrimidinato)-dichromium (II), IP = 3.9 eV).

A stack of several layers may be arranged between the first and second electrode comprising at least a hole transport layer (HTL) and an electron transport layer (ETL), wherein the perovskite active layer is arranged between HTL and ETL and wherein at least one of the hole transport layer (HTL) or electron transport layer (ETL) is doped.

The HTL and / or ETL may comprise several layers, wherein the perovskite active layer is arranged between HTL and ETL and wherein at least one of the hole transport layer (HTL) or electron transport layer (ETL) is doped.

The hole transport layer (HTL) may comprise at least one small organic molecule with IP in the range of 4.5-6.0 eV such as selected from, but not limited to the group consisting of Spiro-MeO-TAD, MeO-TPD, Spiro-MeO-TPD, Spiro-TTB, Spiro-TAD or BPAPF, etc.

The electron transport layer (ETL) may comprises at least one small organic molecule with EA in the range of 3.0-4.5 eV (e.g., a fullerene, fullerene derivative, etc).

The HTL and / or ETL may comprises at least one doped perovskite layer.

The electrode may be selected of transparent conducting oxide (TCO, ITO, etc.), metal nanowire, metal layer, transparent thin metal layer, conductive polymer, DMD, carbon nanotube or graphene.

The perovskite structure may be an organic-inorganic perovskite structure comprising a perovskite of the formula (I), (II) or (III)

A2MX4 (I)

AMX3 (II)

BMX4 (III),

wherein M is a bivalent metal cation selected from the group consisting of Cu2+, Ni2+, Co2+, Fe2+, Mn2+, Cr2+, Pd2+, Cd2+, Ge2+, Pb2+ or Sn2+,
A is potassium or a monovalent organic cation selected from primary, secondary, tertiary or quaternary alkyl ammonium compounds,
B is a bivalent organic cation selected from primary, secondary, tertiary or quaternary alkyl ammonium compounds,
wherein the alkyl-groups independently comprises 1 to 15 aliphatic carbon atoms,
X is a halide such as I, Cl or Br.

May be selected from the group consisting of Pb2+ or Sn2+. Most preferably, M is Pb2+.

According to an embodiment, A is a primary or secondary alkyl ammonium compound, more preferably A is a primary alkyl ammonium compound.

According to an embodiment, any one of the alkyl-groups independently comprises 1 to 8, preferably 1 to 4, more preferably 1 to 2 aliphatic carbon atoms, wherein said alkyl if comprises 3 or more carbons, may be linear, branched or cyclic, and wherein several or all hydrogens in said substituent may be replaced by halogen. Any of the alkyl-groups may be methyl.

The perovskite layer may be applied by any one or more selected from vapor deposition, drop casting, spin-coating, dip-coating and spray-coating, for example.

The dopant concentration in the charge transport layer (6) may be between 0.01 and 12 wt%, more preferably between 0.1 and 10 wt%.

The active layer of the optoelectronic device may comprises at least one organic-inorganic perovskite, wherein the perovskite is doped or undoped.

In an embodiment of this aspect the perovskite is doped with dopants exemplarily selected form the group consisting of F4-TCNQ (Tetrafluoro-tetracyano-quinodimethane) or F6-TCNNQ (1,3,4,5,7,8-hexafluorotetracyanonaphthoquinodimethane) or C60F36 or NDP9 (proprietary dopant from Novaled, GmbH) or molybdenum oxide.

In a further embodiment of this aspect the perovskite is doped with dopants exemplarily selected form the group consisting of AOB (acridine orange base), BEDT-TTF (bis(ethylenedithio)tetrathiafulvalene), W2(hpp)4 (Tetrakis(1,3,4,6,7,8-hexahydro-2H-pyrimido[1,2-a]pyrimidinato)-ditungsten (II)) or Cr2(hpp)4 (Tetrakis(1,3,4,6,7,8-hexahydro-2H-pyrimido[1,2-a]pyrimidinato)-dichromium (II)).

The HTL and / or ETL may comprise several layers, wherein the perovskite active layer is arranged between HTL and ETL and wherein at least one of the HTL or ETL is doped.

According to an embodiment, the optoelectronic device according to the invention contains molecular organic layers where the Fermi level is controlled by adding a dopant ion or molecules. Preferably, the dopant ions or molecules are selected from the group consisting of n-type dopants (e.g. AOB, W2(hpp)4, Cr2(hpp)4, V2(hpp)4, Mo2(hpp)4) and p-type dopants (e.g. F4-TCNQ, F6-TCNNQ, NDP9, C60F36).

Preferably, the matrix material of the molecular organic layer comprises organic polymers and / or small molecules. Typically, the molecular weight of small molecules is below 1000 g / mol such as fullerenes (e.g. C60) or phthalocyanine. A plurality of organic polymer and / or small molecule based optoelectronic devices are well known from prior art (e.g. Walzer et al., Chemical reviews 2007, 107(4), 1233-1271; Peumann et al., J. Appl. Phys. 2003, 93(7), 3693-3722).

For example, the matrix material of the molecular organic layers is selected from, but not limited to the group of small molecules consisting of Spiro-MeO-TAD, MeO-TPD, Spiro-MeO-TPD, Spiro-TTB, Spiro-TAD, BPAPF, pentacene, C60, F16CuPc (Copper(ll)-1,2,3,4,8,9,10,11,15,16,17,18,22,23,24,25-hexadecafluor-29H,31H-phthalocyanin), lr(piq)3 (Tris(1-phenylisoquinoline)iridium(lll)), ZnPC (Zinc phthalocyanine).

A charge injection layer may be provided adjacent to at least one of the first and second electrode. The charge injection layer improves an injection of minority carriers from the first and or second electrode into the inversion channel, respectively.

The charge injection layer may be a hole injection layer (HIL) or an electron injection layer (EIL). It may be useful that the charge injection layer is doped with a dopant ion or molecule of opposite type than a dopant of the doped organic semiconducting layer. The doped semiconducting layer has to be n-doped for p-doped injection layers and p-doped for n-doped injection layers.

Typically, the matrix material of the molecular organic layers and the dopant ions or molecules are chosen with respect to the energy level of both components. For a preferable combination of matrix material and dopant the activation energy required for doping is less than the 50 meV.

The optoelectronic device may be a photo emissive device, a photoabsorptive device, a switching device, or a sensor device.

The optoelectronic device may be a photoactive device such as a solar cell.

The optoelectronic device may comprises a p-n or p-i-n structure. The p-n or p-i-n structure may be formed as homo- or heterojunction.

A method for manufacturing an optoelectronic device, wherein the deposition of the doped transport layers and un-doped / doped perovskite layers is performed by co-evaporation of a the material and / or perovskite and a dopant material. The evaporation is performed under vacuum conditions.

The optoelectronic device comprises at least one perovskite layer, wherein the perovskite layer is a charge carrier transport layer and / or active layer and is either doped or un-doped. In particular the perovskite layer is a hole transport layer (HTL) and / or an electron transport layer (ETL). By doping the perovskite layer, Fermi level control is achieved. The control of the Fermi level has several key advantages like reduction of contact resistance an improvement of the on-off ratio by control of charge carrier concentration in the channel in transistors. In light emitting diodes a reduction of the voltage due to lower transport layer and interference resistance and a wider choice of possible electrodes are achieved. Further to that in solar cells the formation of p-n or p-i-n homojuctions is achieved, thus avoiding hetero-interfaces in the active region. In addition an optimization of the built-in voltage may be achieved which helps to extract carriers from the device. Another advantage of Fermi control is the realization of good electrode contact regardless of energy barriers and the use of highly conductive layers avoiding ohmic losses.

The invention will be explained in more detail with the aid of the following figures and embodiments without limiting the invention to them.

### Detailed Description of Figures

- Fig. 1: depicts a schematic illustration of an optoelectronic device according to the present invention.
- Fig. 2: depicts a schematic illustration of an optoelectronic device with and with out p-n or p-i-n hetero- / homo-junctions.
- Fig. 3: Current-thickness data taken during vacuum deposition of intrinsic (bottom) and NDP9 (top) doped perovskite layers.
- Fig. 4: Current-thickness data taken during vacuum deposition of intrinsic (bottom) and C₆₀F₃₆ (top) doped perovskite layers.
- Fig. 5: General device architecture, corresponding energy level diagram for the materials used in this study, and average (a) short-circuit current density, (b) open-circuit voltage, (c) fill factor, and (d) efficiency values for devices employing these materials Numerical values correspond to the absolute value of the IP and EA as determined by UPS and IPES, respectively.

### Detailed Description of Invention

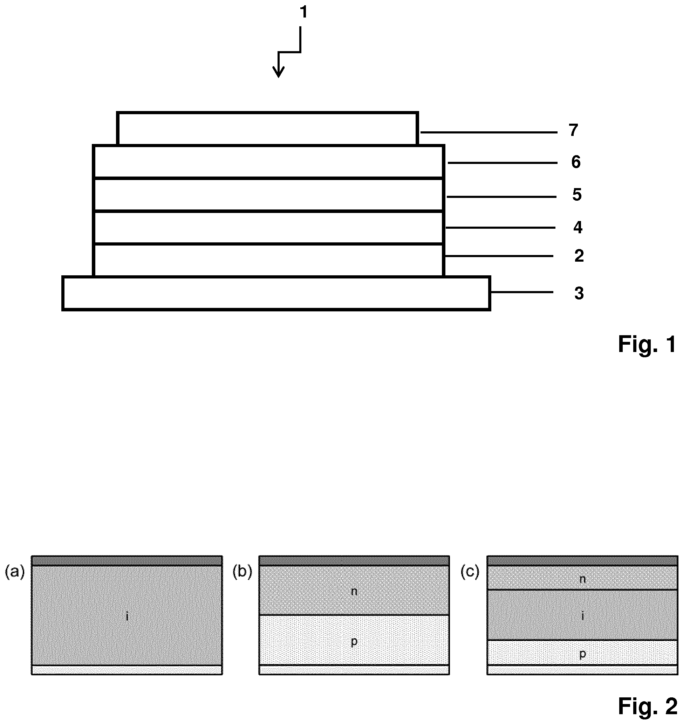

In a first embodiment Fig. 1 depicts a simplified schematic illustration of an optoelectronic device according to the present invention. The optoelectronic device 1 is a solar cell and comprises a first electrode 2 (ITO), which is arranged on a substrate 3 (glass). On the first electrode 2 a hole transport layer (HTL) 4 is deposited. The hole transport layer (HTL) 4 comprises CH₃NH₃PbIX₃ doped with F4-TCNQ. On the hole transport layer (HTL) 4 an active layer 5 is deposited. The active layer 5 comprises an undoped pervoskite, e.g. CH₃NH₃PbIX₃. On the active layer an electron transport layer 6 is deposited. The electron transport layer (ETL) 6 comprises C60. On the top of the electron transport layer 6 is a second electrode deposited, wherein the second electrode comprises at least a metal, wherein the metal is selected from Al, Ag, Au, Ti, Pt, Cr, Zn, Sn, Sr, In, Sc, Hf or a mixture thereof.

In a further embodiment the optoelectronic device 1 is made in accordance to the aforementioned embodiment except that the hole transport layer (HTL) 4 comprises CH₃NH₃PbI(I,Cl)₃ doped with F6-TCNNQ.

In a further embodiment the optoelectronic device 1 comprises a first electrode 2 (ITO), which is arranged on a substrate 3 (glass). On the first electrode 2 a hole transport layer (HTL) 4 is deposited. The hole transport layer (HTL) 4 comprises Spiro-MeO-TAD. On the hole transport layer (HTL) 4 an active layer 5 is deposited. The active layer 5 comprises an undoped pervoskite, e.g. CH₃NH₃PbX₃. On the active layer an electron transport layer 6 is deposited. The electron transport layer (ETL) 6 comprises CH₃NH₃PbX₃ doped with W₂(hpp)₄. On the top of the electron transport layer 6 is a second electrode deposited, wherein the second electrode comprises at least a metal, e.g. Ag.

In a further embodiment the optoelectronic device 1 is made in accordance to the aforementioned embodiment except that the electron transport layer (ETL) 6 comprises CH₃NH₃PbX₃ doped with Cr₂(hpp)₄.

In a further embodiment the optoelectronic device 1 comprises a first electrode 2 (ITO), which is arranged on a substrate 3 (glass). On the first electrode 2 a hole transport layer (HTL) 4 is deposited. The hole transport layer (HTL) 4 comprises p-doped perovskite. On the hole transport layer (HTL) 4 an active layer 5 is deposited. The active layer 5 comprises an undoped pervoskite, *e.g.* CH₃NH₃PbX₃. On the active layer an electron transport layer 6 is deposited. The electron transport layer (ETL) 6 comprises n-doped CH₃NH₃PbX₃. On the top of the electron transport layer 6 is a second electrode deposited, wherein the second electrode comprises at least a metal, *e.g.* Ag.

In a further embodiment the manufacturing of the optoeletronic device is performed by a thermal evaporation under vacuum conditions. Thin film samples are prepared by thermal vapor deposition in ultra-high vacuum (UHV) with a base pressure at or below 10⁻⁷ mbar. The layers in a multi layer device are deposited sequentially and their thicknesses are determined during evaporation using quartz crystal monitors calibrated for the respective material prior to evaporation.

A typical layer structure of substrate, electrode, charge injection layer and charge carrier transport layer or a layout as an optoelectronic device (1) according to the invention as depicted in Fig. 1 comprises independently on the intended purpose
Optoelectronic device (1),
First electrode or anode (2),
Substrate (3),
Hole transport layer (4),
Active layer (5),
Electron transport layer (6),
Second electrode or cathode (7),
optionally one or more charge injection layer (8) or buffer layer to compensate for unevenness of the electrode,
optionally one or more charge blocking layer (9),
encapsulation (10),
but can be customized for each application.

Preferably, all layers are deposited by thermal evaporation in an ultra-high vacuum chamber and / or applied by coating from solution. The production of a multilayer organic structure by coating from solution, however, requires that the solvent is incompatible with the respective preceding layer to solve this not to swell again, or even destroy.

### Examples

The present invention is further described in the following comparative, experiments and examples, which are not intended to limit the scope of the invention.

### Example 1 - Doped Perovskite Layers:

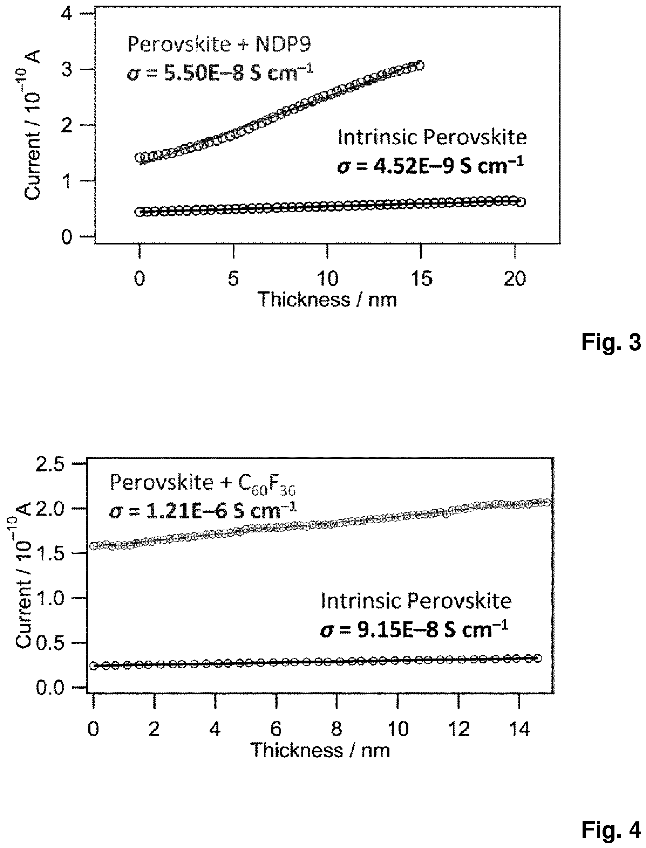

Attempts have been made towards the controlled p-doping of the perovskite active layer. The intrinsic conductivity of the perovskite layer was first measured by *in situ* monitoring of the current response under a pulsed bias during deposition of an intrinsic perovskite film. Doping tests involved the triple-source vapor deposition of the perovskite precursors along with a molecular *p*-dopant (both NDP9 and C₆₀F₃₆ have been investigated). These studies exhibited up to two orders of magnitude improvement in the conductivity (Fig. 3 and Fig. 4) indicating possible doping of the perovskite layer.

The current increase upon an applied voltage (10 V) was measured between the contacts of a meander-like structure (1 nm Cr / 40 nm Au) upon increasing layer thickness of the matrix:dopant films in the channel (*b* = 500 µm, *l* = 0.111 m) during deposition (applied bias: 10 V).

### Example 2 - Doped Transport Layers with Undoped Perovskite Active Layers:

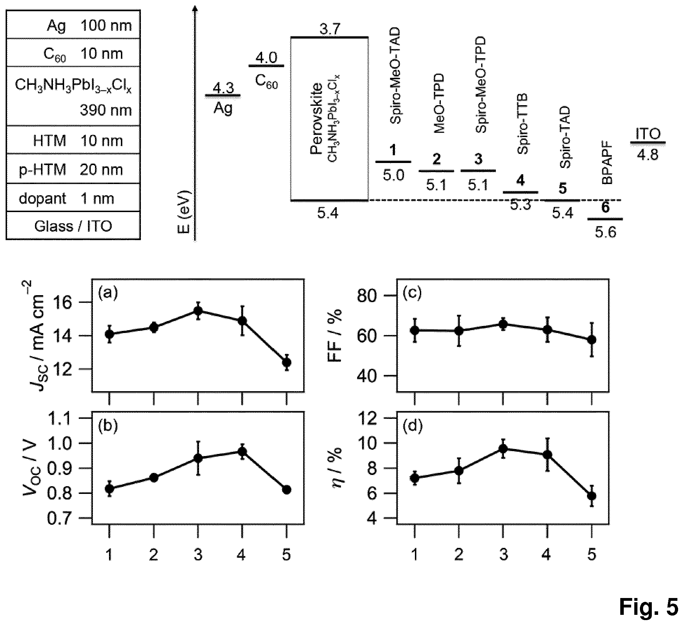

The effect of energy level alignment between the hole-transporting material and the active layer in vacuum deposited, planar-heterojunction CH₃NH₃PbIₓ₋₃Clₓ perovskite solar cells was addressed. Though a series of hole-transport materials (*cf*. Table 1: Spiro-MeO-TAD; MeO-TPD [IP = 5.1 eV]; Spiro-MeO-TPD [IP = 5.1 eV], Spiro-TTB [IP = 5.3 eV], Spiro-TAD [IP = 5.4 eV], BPAPF [IP = 5.6 eV]), with conductivity values set though controlled p-doping of the layer, the ionization potentials (IP) with the open-circuit voltage of the device was correlated. With ionization potentials beyond 5.3 eV, a substantial decrease in both current density and voltage is observed, which highlights the delicate energetic balance between driving force for hole-extraction and maximizing the photovoltage (Fig. 5). In contrast, when an optimal ionization potential match was found, the open-circuit voltage could be maximized, leading to power conversion efficiencies of up to 10.9%. These values were obtained with hole-transport materials that differ from the commonly used Spiro-MeOTAD and correspond to a 40% performance increase compared to this reference. Additionally, this report demonstrates the first example of perovskite active layers being used in combination with doped transport layers.

**Table 1: Ionization potential determined by ultraviolet photoelectron spectroscopy and short-circuit current density, open-circuit voltage, fill-factor, and power-conversion efficiency values measured under simulated AM 1.5 G sunlight (100 mW cm⁻²).**

| HTM | IP_{UPS} (eV) | *J*_{SC} (mA cm⁻²) | *V*_{OC} (V) | FF (%) | *η* (%) |
|---|---|---|---|---|---|
| **1** | 5.0 | 14.4 (14.1 ± 0.5) | 795 (820 ± 30) | 69 (63 ± 5) | 7.8 (7.2 ± 0.5) |
| **2** | 5.0 | 14.9 (14.5 ± 0.3) | 863 (863 ± 10) | 69 (63 ± 7) | 8.7 (7.8 ± 1.0) |
| **3** | 5.1 | 16.0 (15.5 ± 0.5) | 1030 (940 ± 70) | 66 (66 ± 3) | 10.9 (9.6 ± 0.8) |
| **4** | 5.3 | 16.1 (14.9 ± 0.9) | 968 (970 ± 30) | 70 (63 ± 6) | 10.9 (9.1 ± 1.3) |
| **5** | 5.4 | 12.4 (12.2 ± 0.5) | 820 (815 ± 10) | 58 (58 ± 8) | 6.7 (5.8 ± 0.8) |
| **6** | 5.6 | 0.72 | 835 | 13 | 0.08 |

## Claims

1. Optoelectronic device (1) which is arranged on a substrate (3) comprising
- a first electrode (2) adjacent to the substrate (3) and a second electrode (7) which is arranged on top of the device;
- at least one perovskite layer comprising an perovskite structure; and
- at least one charge transport layer (4; 6) which is arranged between the first and the second electrode (2, 7);
wherein the at least one charge transport layer (4; 6) is doped from 0.001 to 15 percent by weight (wt.-%) with a dopant material based on the total weight of the finished charge transport layer (4; 6).

2. Optoelectronic device (1) according to claim 1, wherein the at least one charge transport layer (4; 6) is one of
- a hole transport layer (4), wherein the dopant material is F4-TCNQ, F6-TCNNQ, C₆₀F₃₆, NDP9 or molybdenum oxide; and
- an electron transport layer (6), wherein the dopant is W₂(hpp)₄ or Cr₂(hpp)₄.

3. Optoelectronic device (1) according to claim 1 or 2, wherein the at least one charge transport layer (4; 6) is doped from 0.01 to 12 percent by weight (wt.-%).

4. Optoelectronic device (1) according to claim 1 or 2, wherein the at least one charge transport layer (4; 6) is doped from 0.1 to 10 percent by weight (wt.-%).

5. Optoelectronic device (1) according to at least one of the claims 1 to 4, wherein the perovskite structure is comprising a perovskite of the formula (I), (II) or (III)
A₂MX₄ (I),
AMX₃ (II),
BMX₄ (III),
wherein
M is a bivalent metal cation selected from the group consisting of Cu²⁺, Ni²⁺, Co²⁺, Fe²⁺, Mn²⁺, Cr²⁺, Pd²⁺, Cd²⁺, Ge²⁺, Pb²⁺ or Sn²⁺,
A is potassium or a monovalent organic cation selected from primary, secondary, tertiary or quaternary alkyl ammonium compounds,
B is a bivalent organic cation selected from primary, secondary, tertiary or quaternary alkyl ammonium compounds, and
wherein the alkyl-groups independently comprises 1 to 15 aliphatic carbon atoms, X is a halide such as I, Cl or Br.

6. Optoelectronic device (1) according to at least one of the claims 1 to 5, wherein the optoelectronic device is a light emitting device, a solar cell, a field effector transistor or a sensor.

7. Optoelectronic device (1) according to at least one of the claims 1 to 6, further comprising a p-n or p-i-n structure.

8. Optoelectronic device (1) according to at least one of the claims 1 to 7, comprising the hole transport layer (4) and the electron transport layer (6), wherein
- at least one of the hole transport layer (4) and the electron transport layer (6) is doped;
- at least one of the hole transport layer (4) and the electron transport layer (6) comprises several layers; and
- the at least one perovskite layer is arranged between the hole transport layer (4) and the electron transport layer (6).

9. Optoelectronic device (1) according to at least one of the claims 1 to 8, comprising a charge injection layer provided adjacent to the first electrode (2) or the second electrode (7).

10. Optoelectronic device (1) according to claim 9, wherein the charge injection layer is a hole injection layer or an electron injection layer.

11. Optoelectronic device (1) according to claim 9 or 10, wherein the charge injection layer is doped with a dopant ion or molecule of opposite type than the dopant of the at least one charge transport layer (4; 6).
